# EUROPÄISCHE PATENTSCHRIFT

(11) **EP 4 078 306 B1**
(45) Veröffentlichungstag und Bekanntmachung des Hinweises auf die Patenterteilung: **28.01.2026**
(21) Anmeldenummer: 20829777.0
(22) Anmeldetag: 18.12.2020
(51) Int. Cl.: G05B 19/406

(54) **VERFAHREN UND SYSTEM ZUR ERMITTLUNG DES DYNAMISCHEN VERHALTENS EINER MASCHINE**
METHOD AND SYSTEM FOR DETERMINING THE DYNAMIC BEHAVIOUR OF A MACHINE
PROCÉDÉ ET SYSTÈME PERMETTANT DE DÉTERMINER LE COMPORTEMENT DYNAMIQUE D'UNE MACHINE

(30) Priorität: 20.12.2019 DE 102019135488
(43) Veröffentlichungstag der Anmeldung: 26.10.2022
(73) Patentinhaber: TRUMPF Werkzeugmaschinen SE + Co. KG, 71254 Ditzingen (DE)
(72) Erfinder: KIEWELER, Thomas, 71299 Wimsheim (DE); LUKAS, Martin, 70839 Gerlingen (DE); SCHOBER, Martin, 70839 Gerlingen (DE)
(74) Vertreter: Trumpf Patentabteilung
(86) Internationale Anmeldenummer: PCT/EP2020/087177
(87) Internationale Veröffentlichungsnummer: WO 2021/123276

(56) Entgegenhaltungen:
- EP-A1- 2 690 513
- EP-A1- 3 168 700
- EP-A1- 3 396 485
- EP-A1- 3 425 460
- US-A1- 2019 310 605

## Beschreibung

### Hintergrund der Erfindung

Die Erfindung betrifft ein Verfahren zur Ermittlung des dynamischen Verhaltens einer Maschine mit mehreren Achsen. Außerdem betrifft die Erfindung ein entsprechendes System.

Die zur Beurteilung der dynamischen Eigenschaften von Maschinen, insbesondere Werkzeugmaschinen, eingesetzten Messungen, insbesondere aufwendige Frequenzgangmessungen, werden bisher für jede Achse einzeln positions- bzw. posenabhängig durchgeführt. Eine Aussage über Abhängigkeiten der dynamischen Eigenschaften einer Achse von der eigenen Achsposition und von der Position anderer Achsen sowie das Erkennen komplexer Wirkzusammenhänge ist nur sehr eingeschränkt möglich.

Insbesondere werden im Stand der Technik nur Messungen der dynamischen Eigenschaften an wenigen, ausgewählten Positionen des Arbeitsraums durchgeführt. Dadurch ist die Validität von Aussagen über Ortsabhängigkeiten stark eingeschränkt. Falls Ortsabhängigkeiten zu anderen Achsen untersucht werden sollen, ist dies nur durch Vorkonfiguration einiger Startpositionen möglich. Auch auf diesem Wege werden nur ortsdiskrete Aussagen ermöglicht.

Aus der EP 3 425 460 A1 ist ein Verfahren zur Bestimmung des Zustands einer Spindel einer Werkzeugmaschine bekannt.

Aus der US 2019/0310605 A1 ist ein Verfahren zur Diagnose einer Spindel einer Maschine bekannt.

Aus der EP 3 396 485 A1 ist Verfahren zur Bewertung zumindest einer mechatronischen Kenngröße einer Werkzeugmaschine bekannt.

Aus der EP 3 168 700 A1 ist ein Verfahren zur automatisierten Überwachung einer CNC-gesteuerten Mehrachsmaschine bekannt.

### Aufgabe der Erfindung

Aufgabe der vorliegenden Erfindung ist es, das dynamische Verhalten einer Maschine mit mehreren Achsen über den gesamten Arbeitsraum zu ermitteln.

### Beschreibung der Erfindung

Gelöst wird diese Aufgabe erfindungsgemäß durch ein Verfahren nach Anspruch 1 und ein System nach Anspruch 14.

Bei Werkzeugmaschinen werden Bearbeitungseinheiten, wie Werkzeughalter, die ein Werkzeug halten, oder Laserbearbeitungsköpfe, über Antriebe und möglicherweise dazwischen geschaltete mechanische Komponenten, wie Getriebe oder Portale, an denen die Bearbeitungseinheit befestigt sein kann, in eine bestimmte Achsrichtung bewegt. Abkürzend wird dies häufig mit "Achse" bezeichnet. Eine Achsposition ist somit die Position der Bearbeitungseinheit in der Achsrichtung, die durch die entsprechende Achse bewirkt wird. Der Arbeitsbereich einer Achse ist dabei der Bereich, in dem die Bearbeitungseinheit durch die jeweilige Achse bewegt werden kann. Der Arbeitsraum entsteht durch die Überlagerung der Arbeitsbereiche der Achsen einer Werkzeugmaschine. Der Arbeitsraum ist somit der Raumbereich, der durch die Bearbeitungseinheit erreicht werden kann. Eine Pose oder räumliche Lage ist die Kombination von Position und Orientierung eines Objekts, z.B. einer Bearbeitungseinheit.

Mit dem erfindungsgemäßen Verfahren werden Messfahrten so ausgeführt, dass der gesamte Arbeitsraum abgefahren wird. Für jede Achse werden Messfahrten über den gesamten Arbeitsbereich der zu untersuchenden Achse durchgeführt. Insbesondere können für jede Achse mehrere Messfahrten durchgeführt werden.

Während einer Messfahrt werden Daten unterschiedlicher Datenquellen erfasst und aufgezeichnet. Beispielsweise können an einer Maschine Sensoren als Datenquellen vorgesehen sein, durch die Messungen durchgeführt werden. Auch Steuerungen und Antriebe der Maschine können Datenquellen sein, deren Eingangs- und/oder Ausgangssignale als Daten erfasst werden können.

Die während einer Messfahrt erfassten und aufgezeichneten Daten können entweder zeitsynchron aufgezeichnet werden oder später synchronisiert werden. Die Dauer der Aufzeichnung kann von der Achslänge der zu betrachtenden Achse abhängig sein. Vorzugsweise wird zur Datenerfassung eine kleine, unter Berücksichtigung des zu beobachtenden Systemverhaltens (Abtasttheorem) geeignete Abtastzeit gewählt. Mit dem erfindungsgemäßen Verfahren ist eine ganzheitliche Aussage über Ortsabhängigkeiten der dynamischen Eigenschaften einer Maschine mit Zeit-(Orts-)Frequenzauflösung möglich, die lediglich durch den zur Messung verwendeten Vorschub und die Abtastfrequenz der Datenerfassung beschränkt wird. Insbesondere können Aussagen über die dynamischen Eigenschaften einer Achse in Abhängigkeit von der eigenen Achsposition und von der Position anderer Achsen getroffen werden. So sind globale Aussagen über die kompletten Ortsabhängigkeiten möglich. Wirkzusammenhänge können automatisiert erkannt werden.

Eine Messfahrt für eine Achse kann abschnittsweise erfolgen. Insbesondere können unterschiedliche Abschnitte zu unterschiedlichen Zeiten erfasst werden. In Summe soll jedoch die gesamte Achse, d.h. der gesamte Arbeitsbereich der Achse, erfasst werden.

Die Messfahrt kann in Nebenzeiten oder im laufenden Betrieb der Maschine durchgeführt werden. Nebenzeiten sind dabei Zeiten, in denen keine Werkstückbearbeitung durch die Maschine durchgeführt wird. Es ist jedoch auch denkbar, dass zumindest Abschnitte eines Arbeitsbereichs einer Achse hauptzeitparallel erfasst werden, zum Beispiel beim Positionieren zwischen Konturen, d.h. wenn die Bearbeitungseinheit von einer Bearbeitungsstelle zu einer anderen Bearbeitungsstelle bewegt wird. Es sind jedoch auch Datenaufzeichnungen im laufenden Betrieb der Anlage als Onlinemessungen möglich.

Alternativ können die Messfahrten in einem gesonderten Messprogramm durchgeführt werden. Dass Messprogramm kann beispielsweise vor der eigentlichen Inbetriebnahme einer Maschine durchgeführt werden oder in Nebenzeiten der Maschine.

Anhand der Zeit-Frequenzdarstellung der aufgezeichneten Daten kann das Systemverhalten, insbesondere durch die Datenverarbeitungseinheit, ermittelt werden. Mittels der zeitindizierten Messungen können Spektren von Anregungs- und Ausgangssignal ermittelt werden. Das Verhältnis dieser Spektren ergibt eine Repräsentation des dynamischen Verhaltens des Systems im Frequenzbereich.

Die Analyse der Zeit-Frequenz-Darstellung kann insbesondere automatisiert erfolgen.

Die Messfahrt kann mit einem vorgegebenen Eingangssignal, insbesondere eines Antriebs, durchgeführt werden, wobei das Eingangssignal ein vorgegebenes Signal umfasst, dem ein Anregungssignal überlagert ist. Beispielsweise kann als vorgegebenes Signal eine konstante Geschwindigkeit vorgegeben werden, der ein Anregungssignal überlagert wird. Ein Anregungssignal kann beispielsweise eine technische Näherung eines weißen Rauschens sein. Je nach Typ der durchzuführenden Messfahrt bzw. Messung kann ein bestimmtes geeignetes Geschwindigkeitsprofil vorgegeben werden. Bei den zur Beurteilung von dynamischen Eigenschaften (Diagnose von mechanischen Eigenschaften oder dem Zusammenwirken von regelungstechnischen Einstellungen und mechanischen Eigenschaften) verwendeten Arten von Messungen (zum Beispiel Führungsfrequenzgang Lageregelkreis, Führungsfrequenzgang Drehzahl-/Geschwindigkeitsregelkreis, Störfrequenzgang Drehzahl-/Geschwindigkeitsregelkreis, Drehzahl-/Geschwindigkeitsreglerstrecke, Mechanikfrequenzgang) kann eine konstante Geschwindigkeit als Eingangssignal gewählt werden, der ein geeignetes Anregungssignal überlagert wird.

Zur Diagnose der im Antriebsstrang jeder Achse vorhandenen, an der Bewegung beteiligten Komponenten (zum Beispiel Antrieb, Zahnstangen, Messsysteme) kann das überlagerte Anregungssignal zu Null gesetzt werden. Es können mehrere einzelne Messfahrten mit unterschiedlichen Vorschüben, d.h. Geschwindigkeiten, oder mit anderen geeigneten Geschwindigkeitsprofilen (beispielsweise eine lineare Erhöhung der Geschwindigkeit über die Achsposition) gewählt werden.

Zur Untersuchung von Abhängigkeiten von der Arbeitsraumposition ist ein mehrstufiges Vorgehen denkbar. Zur Berücksichtigung der Abhängigkeiten der dynamischen Eigenschaften von der Arbeitsraumposition anderer als der zu untersuchenden Achse können diese an bestimmten Positionen vorpositioniert werden und die Messung/Messfahrt für jede Pose durchgeführt werden. Es kann also eine andere als die zu untersuchende Achse in unterschiedlichen Positionen vorpositioniert werden und für jede Position der anderen Achse kann eine Messfahrt für die zu untersuchende Achse durchgeführt werden.

Für zumindest eine Achse kann eine Messfahrt durchgeführt werden, während eine andere Achse bewegt wird. Insbesondere ist die gleichzeitige Bewegung mehrerer Achsen in Verbindung mit der Aufzeichnung von Daten in Bezug auf die zu untersuchende Achse möglich. Insbesondere kann bei mehreren gleichzeitig bewegten Achsen deren gegenseitige Beeinflussung durch die entsprechende Überlagerung der Anregungssignale und Aufzeichnungen der Ein- und Ausgangssignale untersucht werden und somit auch eine Abbildung aller bewegten (mechanischen) Komponenten des Gesamtsystems (Werkzeug-)Maschine erstellt werden. Für die Abbildung sind mehrere Formen denkbar. Die Charakterisierung kann im Frequenzbereich als Frequenzgang erfolgen. Weiterhin können Methoden der Systemidentifikation im Zeitbereich, z.B. NARMAX (Nonlinear AutoRegressive Moving Average with eXogenous input), Subspace System Identification etc. benutzt werden. Insbesondere kann bei linearen zeitinvarianten Systemen eine Kopplungsmatrix erstellt werden.

Erfindungsgemäß ist bei einer Messung einer einzelnen Achse die Aufzeichnung des Ein- und Ausgangssignals als Daten über den gesamten Arbeitsbereich der Achse vorgesehen. Als Ausgangssignal können beispielsweise Strom (insbesondere vom Antrieb der Achse aufgenommener Strom), Vorschub, Drehzahl (des Antriebs oder falls ein Getriebe vorhanden ist, des Abtriebs), Beschleunigung, etc. erfasst werden. Zur Untersuchung der Kopplung mehrerer Achsen erhöht sich die Anzahl der aufzuzeichnenden Daten gemäß dem zu untersuchenden Übertragungsverhalten.

Die Erfassung der Daten kann beispielsweise über eine Datenerfassungseinheit erfolgen, die in der Lage ist, die Daten über den gesamten Zeitraum der Messung, insbesondere einer Messfahrt, zeitsynchron aufzuzeichnen. Die Datenerfassungseinheit kann Teil einer Steuerung (der Maschine) sein und mit einer Speichereinheit zusammenwirken. Alternativ kann die Datenerfassungseinheit eine externe Komponente, wie zum Beispiel ein IPC (Industrie PC) oder eine echtzeitfähige Datenerfassungseinheit mit mindestens einer physikalischen Kommunikationsschnittstelle und insbesondere mit einer Datenspeicherungsfunktionalität sein, die mit den Datenquellen verbunden ist, sodass eine Aufzeichnung der Daten und entsprechende Speicherung möglich ist.

Die Zeit-Frequenz-Darstellung kann beispielsweise mittels einer Transformation, insbesondere Fourier-Transformation, quadratischer Transformation oder Wigner-Ville-Verteilung, ermittelt werden. Beispielsweise kann eine Kurzzeit-Fourier-Transformation durchgeführt werden. Für zumindest eine Achse kann der Zeitbezug in einen Ortsbezug umgerechnet werden. Die Analyse bzw. Bewertung der Darstellung im Bildbereich erfolgt mittels Bildverarbeitungsalgorithmen anhand festgelegter Indikatoren, beispielsweise anhand statistischer Werte für einzelne Merkmale wie Schwellwerte mit/ohne Ortsbezug. Weiterhin kann die Analyse anhand der Darstellung selbst als hochkorrelierter Tensor erfolgen, der in der Datenverarbeitungseinheit weiterverarbeitet wird. Beispielsweise können die Daten des Bodediagramms in zwei Matrizen, bei denen die Amplitudeninformation separat in einer und die Phaseninformation in einer anderen Matrix ortsabhängig in einen normierten Grauwert umgerechnet wird, erfolgen. Damit ist es möglich, die Daten mithilfe von Bildverarbeitungsalgorithmen zu untersuchen und neuronale Netze zu trainieren, um die bisherigen serienabhängigen, nur lokal gültigen Untersuchungsmethoden durch ganzheitliche Verfahren abzulösen. Dies führt zu einem deutlich vereinfachten Diagnoseprozess.

Weitere Parameter wie Lebensdauer und Verschleiß von Komponenten sowie Serviceeinsätze können bei der Analyse der Daten berücksichtigt werden. Diese Analyse kann in Bezug auf eine Population oder in Bezug auf den zeitlichen Verlauf derselben oder ähnlicher Maschinen pro Merkmal erfolgen, was auch die Identifikation relevanter Merkmale automatisiert ermöglicht. Die Population kann die Menge der Systeme (=(Werkzeug-)Maschine) mit nominell identischen Charakteristika (= Motor, Getriebe, Maschinenkörper etc.) sein. Die "Merkmale", die aus Messungen extrahiert werden, können z.B. Eigenfrequenzen, Dämpfungen, Hysteresen etc. sein. Diese Merkmale sind statistisch verteilt. Die Charakteristika dieser Verteilungen (z.B. Mittelwerte, Standardabweichungen), können ihrerseits relevant zur Charakterisierung einer Population sein.

Wenn z.B. die Standardabweichung einer Eigenfrequenz bei Maschinen aus Produktionslinie A größer ist als aus Produktionslinie B, deutet dies auf Unterschiede im (nominell identischen) Produktionsprozess hin.

Die Bildverarbeitungsalgorithmen können maschinelles Lernen umfassen. Insbesondere können die Algorithmen ein statistisches Modell aufbauen, das auf Trainingsdaten, d.h. den erfassten Daten, beruht. Insbesondere können Muster und Gesetzmäßigkeiten in den erfassten Daten erkannt werden. So können auch unbekannte Daten nach Abschluss des Lernprozesses beurteilt werden. Eine mögliche angewandte Lernvariante mittels künstlicher neuronaler Netze ist das sogenannte DeepLearning, welches erfindungsgemäß angewendet werden kann. Darunter können beispielsweise Convolutional Neural Networks, Deep Auto Encoder, Generative Adversarial Networks fallen.

Insbesondere kann vorgesehen sein, dass ein künstliches neuronales Netz trainiert wird, in dem die Analyse der Darstellung im Bildbereich dem neuronalen Netz zugeführt wird.

Dem neuronalen Netz können Metadaten zur Verfügung gestellt werden. Insbesondere können Informationen aus anderen Datenquellen, zum Beispiel dem Daten-Labeling anhand von Serviceeinsatzhistorien (zum Beispiel Informationen über durchgeführte Tätigkeiten oder getauschte Komponenten) dem neuronalen Netz zugeführt werden. Diese Metadaten können bei der Analyse zur automatischen Klassifizierung von Messdaten berücksichtigt werden. Somit ist ein automatisiertes Erkennen komplexer Wirkzusammenhänge möglich.

Zumindest einige der Verfahrensschritte können auf räumlich verteilten Systemen durchgeführt werden. Beispielsweise kann der Bildverarbeitungsalgorithmus auf der Maschine, auf einer echtzeitfähige Datenerfassungseinheit mit mindestens einer physikalischen Kommunikationsschnittstelle und insbesondere mit einer Datenspeicherungs-funktionalität, auf einem Rechner oder in einer Cloudstruktur ausgeführt werden.

In den Rahmen der Erfindung fällt außerdem ein System zur Ermittlung des dynamischen Verhaltens einer Maschine mit mehreren Achsen, mit einer Maschine, insbesondere Werkzeugmaschine, die mehrere Achsen aufweist, zumindest einer Datenquelle, die mit einer Datenerfassungseinheit verbunden ist, einer Datenspeichereinheit zur Speicherung der erfassten Daten und einer Datenverarbeitungseinheit, die eingerichtet ist, eine Zeit-Frequenz-Darstellung der aufgezeichneten Daten zu ermitteln, sowie einer Bildverarbeitungseinrichtung zur Verarbeitung der Zeit-Frequenz-Darstellung. Die Datenquellen können maschineninterne Datenquellen oder maschinenexterne Datenquellen sein. Maschineninterne Datenquellen können beispielsweise Strom-, Beschleunigungs-, Geschwindigkeit-, Lage-Ist- und/oder Sollwerte liefern. Weiterhin können maschineninterne Datenquellen aus Steuerungen stammen, beispielsweise einer speicherprogrammierbaren Steuerung (PLC) oder einer numerischen Steuerung (NC). Zudem können die Antriebe der Achsen Datenquellen darstellen. Weiterhin können Datenquellen Laserleistung, Gasdruck, Streulicht etc. als Daten liefern.

Maschinenexterne Datenquellen können beispielsweise Mikrofone, Micro-Electro-Mechanical-Systems (MEMS) Sensoren, oder Kameras sein. Die Datenerfassungseinheit kann Teil einer Steuerung sein. Alternativ kann die Datenerfassungseinheit eine externe Komponente zur Datenerfassung sein, beispielsweise eine echtzeitfähige Datenerfassungseinheit mit mindestens einer physikalischen Kommunikationsschnittstelle und insbesondere mit einer Datenspeicherungs-funktionalität oder ein IPC.

Die Bildverarbeitungseinrichtung kann als neuronales Netz ausgebildet sein oder ein solches umfassen. Mit einer solchen Bildverarbeitungseinrichtung ist es möglich, selbstlernende Algorithmen der Bildverarbeitung einzusetzen, insbesondere maschinelles Lernen und sogenanntes DeepLearning. Weiterhin ist es möglich, die Daten anhand von zusätzlichen Informationen zu klassifizieren, beispielsweise aufgrund von Serviceeinsatzberichten, Ersatzteiltausch etc. Somit ist es möglich, eine ganzheitliche Aussage über Ortsabhängigkeiten der dynamischen Eigenschaften einer Werkzeugmaschine mit Zeit-(Orts)-Frequenz-Auflösung zu treffen, die lediglich durch den zur Messung verwendeten Vorschub und die Abtastfrequenz bei der Datenerfassung beschränkt wird. Lokale Abweichungen des untersuchten Systems können detektiert werden. Weiterhin kann eine globale Aussage über Ortsabhängigkeiten in deutlich kürzerer Zeit als bisher gemacht werden. Komplexe Wirkzusammenhänge können automatisiert erkannt werden.

Weitere Merkmale und Vorteile der Erfindung ergeben sich aus der nachfolgenden detaillierten Beschreibung eines Ausführungsbeispiels der Erfindung, anhand der Figuren der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung ist ein Ausführungsbeispiel der Erfindung dargestellt und in der nachfolgenden Beschreibung erläutert.

Es zeigen:
- Fig. 1: ein erfindungsgemäßes System zur Ermittlung des dynamischen Verhaltens einer Maschine;
- Fig. 2: eine Orts-Frequenz-Darstellung von Daten;
- Fig. 3: ein Flussdiagramm des erfindungsgemäßen Verfahrens.

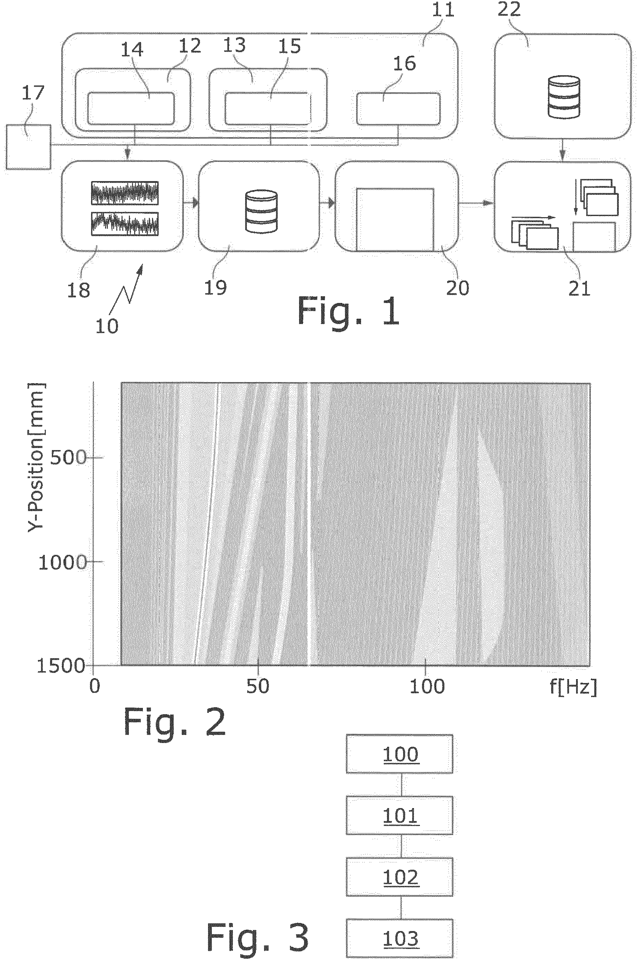

**Fig. 1** zeigt ein System 10 zur Ermittlung des dynamischen Verhaltens einer Maschine 11, die mehrere Achsen 12, 13 aufweist. Die Maschine 11 weist weiterhin Datenquellen 14, 15, 16 auf, wobei die Datenquellen 14, 15 den Achsen 12, 13 zugeordnet sind. Es kann sich hierbei insbesondere um eine interne Sensorik handeln. Weiterhin können die Datenquellen 14, 15 Steuerungen sein. Als Daten können beispielsweise Strom oder Drehzahl ausgegeben werden. Die Maschine 11 kann weitere Datenquellen 16 aufweisen, die beispielsweise als Sensoren ausgebildet sind. Beispielsweise kann auf diese Weise eine Beschleunigung einer Bearbeitungseinheit erfasst werden. Zusätzlich können externe Datenquellen 17 vorgesehen sein. Die Datenquelle 17 kann beispielsweise als Mikrofon oder Kamera ausgebildet sein. Durch die Verwendung von zusätzlichen Datenquellen, beispielsweise Beschleunigungssensoren, Drehratensensoren, Mikrofonen, Kameras etc., können charakterisierende Systemeigenschaften bestimmt werden.

Die von den Datenquellen 14, 15, 16, 17 erfassten Daten werden einer Datenerfassungseinheit 18 zugeführt. Die von den Datenquellen 14, 15, 16, 17 stammenden Daten können zeitsynchronisiert aufgezeichnet werden, insbesondere können die Datenquellen 14-17 synchronisiert werden. Alternativ können die Daten nachträglich, beispielsweise in der Datenerfassungseinheit 18, synchronisiert werden. Insbesondere kann die Datenerfassungseinheit 18 eingerichtet sein, die Daten über den gesamten Zeitraum der Messung zeitsynchron aufzuzeichnen. Die Datenerfassungseinheit 18 kann Teil einer Steuerung sein. Im gezeigten Ausführungsbeispiel ist sie als externe echtzeitfähige Datenerfassungseinheit mit mindestens einer physikalischen Kommunikationsschnittstelle und insbesondere mit einer Datenspeicherungsfunktionalität ausgebildet.

Während der Datenerfassung wird eine Achse 12, 13 oder Maschine 11 über ihren gesamten Arbeitsbereich verfahren. Ein mögliches Eingangssignal ist eine konstante Geschwindigkeit für eine einzelne Achse des Systems (vorgegebene konstante Geschwindigkeit für die Bewegung einer Bearbeitungseinheit durch die Achse), die mit einem Anregungssignal überlagert ist. Das Ausgangssignal, also die durch die Datenquellen 14-17 gelieferten Daten, kann beispielsweise dem Strom, dem Vorschub, der Drehzahl oder der Beschleunigung entsprechen.

Zur Untersuchung der Kopplung mehrerer Achsen 12, 13 erhöht sich die Anzahl der aufzuzeichnenden Daten. Die aufgezeichneten Daten werden in einer Datenspeichereinheit 19 gespeichert. Anschließend erfolgt eine Datenverarbeitung oder Datenvorverarbeitung in einer Datenverarbeitungseinheit 20. Hier wird insbesondere eine Zeit-Frequenz-Darstellung der aufgezeichneten Daten bestimmt. Alternativ oder zusätzlich kann das Systemverhalten der Maschine 11 ermittelt werden, beispielsweise als Übertragungsfunktion unter Annahme eines linearen zeitinvarianten Systems oder als Repräsentation mittels des NARMAX-Ansatzes. Optional kann anschließend eine Umrechnung der Zeit-Frequenz-Darstellung in eine Orts-Frequenz-Darstellung erfolgen.

In einer Bildverarbeitungseinrichtung 21 erfolgt anschließend eine Analyse der Daten. Insbesondere kann eine Bewertung der aus der Zeit-Frequenz-Transformation resultierenden Darstellung im Bildbereich anhand festgelegter Indikatoren erfolgen. Zum Beispiel können statistische Werte für einzelne Merkmale, wie Schwellwerte mit und ohne Ortsbezug, ermittelt werden. Die Darstellung selbst kann als hochkorrelierter Tensor weiterverarbeitet werden. Ein Ansatz ist beispielsweise die Darstellung der Informationen des Bodediagramms in zwei Matrizen, mit denen die Amplitudeninformation separat in einer und die Phaseninformation in einer anderen Matrix ortsabhängig in einen normierten Grauwert umgerechnet wird. Damit ist es möglich, die Daten mithilfe moderner Bildverarbeitungsalgorithmen, insbesondere unter Verwendung von maschinellem Lernen, zu untersuchen und geeignete neuronale Netze zu trainieren, um die bisherigen serienabhängigen, nur lokal gültigen Untersuchungsmethoden durch ganzheitliche Verfahren abzulösen. Dies führt zu einem deutlich vereinfachten Diagnoseprozess, inklusive einer Bestimmung der für die Untersuchung relevanten Eigenschaften.

Der Bildverarbeitungseinrichtung 21 können durch einen weiteren Speicher 22 sogenannte Metadaten zugeführt werden. Somit können weitere Parameter bei der Datenanalyse berücksichtigt werden. Weitere Parameter sind beispielsweise die Lebensdauer einer Maschine, Verschleiß, Serviceeinsätze, etc.

Die **Fig. 2** zeigt ein Orts-Frequenz-Diagramm. Dieses wurde ermittelt, indem der Frequenzgang der x-Achse einer Maschine gemessen wurde, während sich die y-Achse bewegt hat. Dabei zeigen die Farben bzw. Graustufen die Amplitude des Frequenzgangs. Aufgrund dieser Darstellung lässt sich zu jeder Zeit und an jeder Stelle der Frequenzgang der x-Achse ermitteln. Es sind somit nicht nur wie bisher punktuelle Daten vorhanden, sondern es kann global im gesamten Arbeitsbereich der x-Achse ein Frequenzgang ermittelt werden.

Die **Fig. 3** zeigt ein Flussdiagramm des erfindungsgemäßen Verfahrens. In Schritt 100 wird für jede Achse über deren gesamten Arbeitsbereich mindestens eine Messfahrt durchgeführt.

Im Schritt 101 werden Daten erfasst und aufgezeichnet, die mit der Messfahrt in Verbindung stehen. Im Schritt 102 wird mittels einer Datenverarbeitungseinheit eine Zeit-Frequenz-Darstellung von aufgezeichneten Daten ermittelt. Im Schritt 103 erfolgt eine Analyse der Zeit-Frequenz-Darstellung oder einer damit in Beziehung stehenden Darstellung, z.B. einer Orts-Frequenz-Darstellung, mittels eines Bildverarbeitungsalgorithmus.

## Patentansprüche

1. Verfahren zur Ermittlung des dynamischen Verhaltens einer Maschine (11) mit zumindest einer Achse (12, 13) mit den Verfahrensschritten:
a. Durchführen einer Messfahrt für jede Achse (12, 13) über deren gesamten Arbeitsbereich, wobei jede Achse während der Datenerfassung über ihren gesamten Arbeitsbereich verfahren wird;
b. Erfassen und Aufzeichnen von Daten, die mit der Messfahrt in Verbindung stehen, wobei während der Messfahrt Daten unterschiedlicher Datenquellen (14, 15, 16, 17) erfasst und aufgezeichnet werden;
c. Mittels einer Datenverarbeitungseinheit (20) Ermitteln einer Zeit-Frequenzdarstellung von aufgezeichneten Daten;
d. Bewertung der Zeit-Frequenz-Darstellung oder einer damit in Beziehung stehenden Orts-Frequenz-Darstellung, mittels eines Bildverarbeitungsalgorithmus anhand festgelegter Indikatoren.

2. Verfahren nach Anspruch 1, **dadurch gekennzeichnet, dass** die Messfahrt für eine Achse (12, 13) abschnittsweise erfolgt.

3. Verfahren nach einem der vorhergehenden Ansprüche, **dadurch gekennzeichnet, dass** die Messfahrt in Nebenzeiten oder im laufenden Betrieb der Maschine (11) durchgeführt wird.

4. Verfahren nach einem der vorhergehenden Ansprüche, **dadurch gekennzeichnet, dass** die Messfahrt mit einem vorgegebenen Eingangssignal durchgeführt wird, wobei das Eingangssignal ein vorgegebenes Signal umfasst, dem ein Anregungssignal überlagert ist.

5. Verfahren nach einem der vorhergehenden Ansprüche, **dadurch gekennzeichnet, dass** für zumindest eine Achse (12, 13) mehrere Messfahrten mit unterschiedlichen Eingangssignalen durchgeführt werden.

6. Verfahren nach einem der vorhergehenden Ansprüche, **dadurch gekennzeichnet, dass** für zumindest eine Achse (12, 13) eine Messfahrt durchgeführt wird, während eine andere Achse bewegt wird.

7. Verfahren nach einem der vorhergehenden Ansprüche, **dadurch gekennzeichnet, dass** eine andere Achse (12, 13) in unterschiedlichen Positionen vorpositioniert wird und für jede Position der anderen Achse (12, 13) eine Messfahrt durchgeführt wird.

8. Verfahren nach einem der vorhergehenden Ansprüche, **dadurch gekennzeichnet, dass** die Zeit-Frequenz-Darstellung mittels einer Transformation, insbesondere Fourier-Transformation, quadratischer Transformation oder Wigner-Ville Verteilung, ermittelt wird.

9. Verfahren nach einem der vorhergehenden Ansprüche, **dadurch gekennzeichnet, dass** für zumindest eine Achse (12, 13) der Zeitbezug in einen Ortsbezug umgerechnet wird.

10. Verfahren nach einem der vorhergehenden Ansprüche, **dadurch gekennzeichnet, dass** die Bewertung der Darstellung im Bildbereich mittels Bildverarbeitungsalgorithmen erfolgt.

11. Verfahren nach einem der vorhergehenden Ansprüche, **dadurch gekennzeichnet, dass** ein künstliches neuronales Netz trainiert werden, indem die Analyse der Darstellung im Bildbereich dem neuronalen Netz zugeführt wird.

12. Verfahren nach einem der vorhergehenden Ansprüche, **dadurch gekennzeichnet, dass** dem neuronalen Netz Metadaten zur Verfügung gestellt werden.

13. Verfahren nach einem der vorhergehenden Ansprüche, **dadurch gekennzeichnet, dass** zumindest einige der Verfahrensschritte auf räumlich verteilten Systemen durchgeführt werden.

14. System (10) zur Ermittlung des dynamischen Verhaltens einer Maschine (11) mit mehreren Achsen (12, 13), mit einer Maschine (11), die mehrere Achsen (12, 13) aufweist, zumindest einer Datenquelle (14 - 17), die mit einer Datenerfassungseinheit (18) verbunden ist, einer Datenspeichereinheit (19) zur Speicherung der erfassten Daten und einer Datenverarbeitungseinheit (20) , die eingerichtet ist, eine Zeit-Frequenz-Darstellung der aufgezeichneten Daten zu ermitteln, sowie einer Bildverarbeitungseinrichtung (21) zur Verarbeitung der Zeit-Frequenz-Darstellung, wobei das System (10) dazu eingerichtet ist ein Verfahren nach einem der Ansprüche 1 bis 13 durchzuführen.

15. System nach Anspruch 14, **dadurch gekennzeichnet, dass** die Bildverarbeitungseinrichtung (21) als neuronales Netz ausgebildet ist oder ein solches umfasst.

## Claims

1. A method for determining the dynamic response of a machine (11) having at least one axis (12, 13), comprising the method steps:
a. carrying out a measurement run for each axis (12, 13) over the entire working range thereof, wherein each axis is moved over its entire working range during data collection;
b. collecting and recording data that relate to the measurement run, wherein data from different data sources (14, 15, 16, 17) are collected and recorded during the measurement run;
c. determining, by means of a data processing unit (20), a time-frequency representation of recorded data;
d. evaluating the time-frequency representation, or a location-frequency representation related thereto, by means of an image processing algorithm with the aid of established indicators.

2. The method according to claim 1, **characterized in that** the measurement run for an axis (12, 13) takes place in sections.

3. The method according to any of the preceding claims, **characterized in that** the measurement run is carried out during downtimes or while the machine (11) is operating.

4. The method according to any of the preceding claims, **characterized in that** the measurement run is carried out with a predefined input signal, wherein the input signal comprises a predefined signal with an excitation signal superimposed thereon.

5. The method according to any of the preceding claims, **characterized in that** for at least one axis (12, 13) a plurality of measurement runs are carried out with different input signals.

6. The method according to any of the preceding claims, **characterized in that** for at least one axis (12, 13) a measurement run is carried out while another axis is being moved.

7. The method according to any of the preceding claims, **characterized in that** another axis (12, 13) is pre-positioned in different positions, and a measurement run is carried out for each position of said other axis (12, 13).

8. The method according to any of the preceding claims, **characterized in that** the time-frequency representation is determined by means of a transformation, in particular a Fourier transformation, quadratic transformation or Wigner-Ville distribution.

9. The method according to any of the preceding claims, **characterized in that** for at least one axis (12, 13), the time reference is converted to a location reference.

10. The method according to any of the preceding claims, **characterized in that** the evaluation of the representation in the image region takes place by means of image processing algorithms.

11. The method according to any of the preceding claims, **characterized in that** an artificial neural network is trained by feeding the analysis of the representation in the image region to the neural network.

12. The method according to any of the preceding claims, **characterized in that** metadata are made available to the neural network.

13. The method according to any of the preceding claims, **characterized in that** at least some of the method steps are carried out on spatially distributed systems.

14. A system (10) for determining a dynamic response of a machine (11) having a plurality of axes (12, 13), the system comprising a machine (11) with a plurality of axes (12, 13), at least one data source (14 - 17) connected to a data collection unit (18), a data storage unit (19) for storing the collected data and a data processing unit (20) that is configured to determine a time-frequency representation of recorded data, as well as an image processing device (21) for processing the time-frequency representation, wherein the system (10) is configured to carry out a method according to any of the claims 1 to 13.

15. The system according to claim 14, **characterized in that** the image processing device (21) is designed as a neural network or comprises the same.

## Revendications

1. Procédé de détermination du comportement dynamique d'une machine (11) à au moins un axe (12, 13), comprenant comme étapes du procédé :
a. effectuer un parcours de mesure pour chaque axe (12, 13) sur toute sa plage de travail, dans lequel chaque axe est déplacé sur toute sa plage de travail pendant l'acquisition de données ;
b. recueillir et enregistrer des données liées au parcours de mesure, dans lequel, pendant le parcours de mesure, des données provenant de différentes sources de données (14, 15, 16, 17) sont recueillies et enregistrées ;
c. au moyen d'une unité de traitement de données (20), déterminer une représentation temps-fréquence des données enregistrées ;
d. évaluer de la représentation temps-fréquence ou d'une représentation lieu-fréquence en rapport avec celle-ci, au moyen d'un algorithme de traitement d'image sur la base d'indicateurs prédéfinis.

2. Procédé selon la revendication 1, **caractérisé en ce que** le parcours de mesure pour un axe (12, 13) a lieu par sections.

3. Procédé selon l'une quelconque des revendications précédentes, **caractérisé en ce que** le parcours de mesure est effectué pendant les heures creuses ou pendant le fonctionnement de la machine (11).

4. Procédé selon l'une quelconque des revendications précédentes, **caractérisé en ce que** le parcours de mesure est effectué avec un signal d'entrée prédéfini, dans lequel le signal d'entrée comprend un signal prédéfini auquel est superposé un signal d'excitation.

5. Procédé selon l'une quelconque des revendications précédentes, **caractérisé en ce que**, pour au moins un axe (12, 13), plusieurs parcours de mesure sont effectués avec différents signaux d'entrée.

6. Procédé selon l'une quelconque des revendications précédentes, **caractérisé en ce que**, pour au moins un axe (12, 13), un parcours de mesure est effectué pendant qu'un autre axe est déplacé.

7. Procédé selon l'une quelconque des revendications précédentes, **caractérisé en ce qu'**un autre axe (12, 13) est prépositionné dans différentes positions et qu'un parcours de mesure est effectué pour chaque position de l'autre axe (12, 13).

8. Procédé selon l'une quelconque des revendications précédentes, **caractérisé en ce que** la représentation temps-fréquence est déterminée au moyen d'une transformation, en particulier une transformation de Fourier, une transformation quadratique ou une distribution de Wigner-Ville.

9. Procédé selon l'une quelconque des revendications précédentes, **caractérisé en ce que**, pour au moins un axe (12, 13), la référence temporelle est convertie en une référence spatiale.

10. Procédé selon l'une quelconque des revendications précédentes, **caractérisé en ce que** l'évaluation de la représentation dans la zone d'image a lieu au moyen d'algorithmes de traitement d'image.

11. Procédé selon l'une quelconque des revendications précédentes, **caractérisé en ce qu'**un réseau neuronal artificiel est entraîné en fournissant au réseau neuronal l'analyse de la représentation dans la zone d'image.

12. Procédé selon l'une quelconque des revendications précédentes, **caractérisé en ce que** des métadonnées sont mises à la disposition du réseau neuronal.

13. Procédé selon l'une quelconque des revendications précédentes, **caractérisé en ce qu'**au moins certaines des étapes du procédé sont effectuées sur des systèmes répartis dans l'espace.

14. Système (10) de détermination du comportement dynamique d'une machine (11) à plusieurs axes (12, 13), comprenant une machine (11) qui présente plusieurs axes (12, 13), au moins une source de données (14 à 17) qui est reliée à une unité d'acquisition de données (18), une unité d'enregistrement de données (19) pour enregistrer les données recueillies et une unité de traitement de données (20) qui est conçue pour déterminer une représentation temps-fréquence des données enregistrées, ainsi qu'un dispositif de traitement d'image (21) pour traiter la représentation temps-fréquence, dans lequel le système (10) est conçu pour effectuer un procédé selon l'une quelconque des revendications 1 à 13.

15. Système selon la revendication 14, **caractérisé en ce que** le dispositif de traitement d'image (21) est conçu comme un réseau neuronal ou comprend un tel réseau.
